# EUROPÄISCHE PATENTSCHRIFT

(11) **EP 0 304 591 B1**
(45) Veröffentlichungstag und Bekanntmachung des Hinweises auf die Patenterteilung: **03.03.1993**
(21) Anmeldenummer: 88110880.7
(22) Anmeldetag: 07.07.1988
(51) Int. Cl.: G11C 7/00, G11C 8/00, G11C 11/419

(54) **Halbleiterspeicher mit einer Signalwechsel-Erkennungsschaltung**
Semiconductor memory with signal change detector circuit
Mémoire à semi-conducteurs avec détecteur de changement de signal

(30) Priorität: 18.08.1987 DE 3727548
(43) Veröffentlichungstag der Anmeldung: 01.03.1989
(73) Patentinhaber: SIEMENS AKTIENGESELLSCHAFT, 80333 München (DE)
(72) Erfinder: Mattausch, Hans-Jürgen, Dr. rer. nat., D-8011 Kirchheim (DE)

(56) Entgegenhaltungen:
- EP-A- 0 107 415
- EP-A- 0 139 385
- US-A- 4 558 435
- PATENT ABSTRACTS OF JAPAN, Band 7, Nr. 216 (P-225)[1361], 24. September 1983; & JP-A-58 108 091
- IBM TECHNICAL DISCLOSURE BULLETIN, Band 30, Nr. 1, Juni 1987, Seiten 304-305, New York, US; "Power reduction scheme with data-dependent write"
- PATENT ABSTRACTS OF JAPAN, Band 6, Nr. 188 (P-144)[1066], 28. September 1982; & JP-A-57 100 688

## Beschreibung

Die Erfindung bezieht sich auf einen Halbleiterspeicher mit einer Signalwechsel-Erkennungsschaltung nach dem Oberbegriff des Patentanspruchs 1.

Ein Halbleiterspeicher dieser Art ist aus der EP-A-0 107 415 bekannt. Dort wird in der Signalwechsel-Erkennungsschaltung aus jedem Adreßsignalwechsel ein Ausgangssignal abgeleitet, das zunächst einem ersten Steuereingang der Vorladeschaltung zugeführt wird, an dem es eine Deaktivierung derselben veranlaßt. Andererseits wird das Ausgangssignal über eine Verzögerungseinheit einem zweiten Steuereingang der Vorladeschaltung zugeführt, an dem es eine Reaktivierung derselben bewirkt. Die Verzögerungseinheit verzögert das Ausgangssignal dabei um eine feste Zeitspanne, die für den zeitaufwendigsten Speicherzugriff vorgesehen werden muß.

Der Erfindung liegt die Aufgabe zugrunde, einen Halbleiterspeicher der eingangs genannten Art anzugeben, bei dem eine aus Signalwechseln abgeleitete Taktung der Vorladeschaltung wesentlich besser auf die tatsächliche Dauer der einzelnen Speicherzugriffe abgestimmt werden kann, als das bei dem vorstehend erwähnten, bekannten Halbleiterspeicher der Fall ist. Das wird erfindungsgemäß durch eine Ausbildung nach dem Kennzeichen des Patentanspruchs 1 erreicht.

Der mit der Erfindung erzielbare Vorteil liegt insbesondere darin, daß die Reaktivierung der Vorladeschaltung baldmöglichst nach der Beendigung jedes einzelnen Speicherzugriffs erfolgen kann, so daß der Speicher in jeweils kürzester Zeit für einen neuen Zugriff wieder zur Verfügung steht. Ein weiterer Vorteil besteht darin, daß die extrem schnelle Reaktivierung der Vorladeschaltung auch unabhängig von der Anzahl der Speicherzellen im Speicherfeld und damit unabhängig von der hierdurch bedingten unterschiedlichen Dauer der Speicherzugriffe gewährleistet ist.

Bevorzugte Ausgestaltungen und Weiterbildungen der Erfindung sind in den Patentansprüchen 2 bis 13 angegeben.

Die Erfindung wird nachfolgend anhand der in der Zeichnung dargestellten, bevorzugten Ausführungsbeispiele näher erläutert. Dabei zeigt:
- Fig. 1: das Blockschaltbild eines erfindungsgemäßen Halbleiterspeichers,
- Fig. 2: die Prinzipschaltung einer Speicherzelle des Speichers nach Fig. 1,
- Fig. 3: Spannungs-Zeit-Diagramme zur Erläuterung der Wirkungsweise des Speichers nach Fig. 1,
- Fig. 4: das Prinzipschaltbild einer Teilschaltung von Fig. 1,
- Fig. 5: das Prinzipschaltbild einer anderen Teilschaltung von Fig. 1 und
- Fig. 6: eine alternative Ausbildung der Teilschaltung nach Fig. 5.

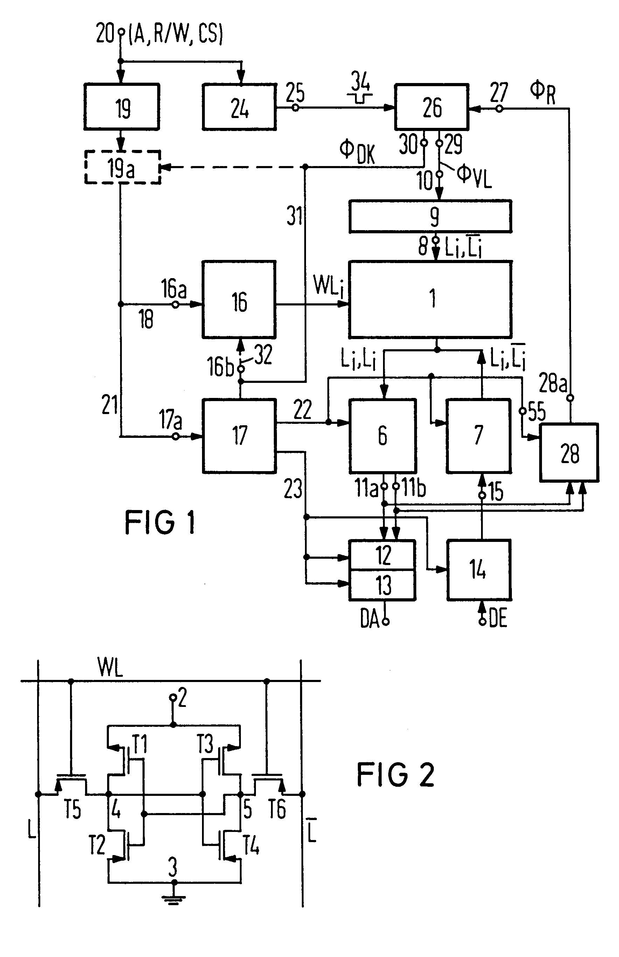

In Fig. 1 bezeichnet 1 ein Speicherfeld, das aus einer Vielzahl von z.B. nach Fig. 2 ausgebildeten, statischen Speicherzellen in komplementärer Schaltungstechnik aufgebaut ist. Jede dieser Speicherzellen weist gemäß Fig. 2 zwei kreuzgekoppelte Inverter auf, von denen der erste aus der Serienschaltung zweier Feldeffekttransistoren T1 und T2 besteht, der zweite aus der Serienschaltung zweier Feldeffekttransistoren T3 und T4. Die Sourceanschlüsse der p-Kanal-Transistoren T1 und T3 sind mit einem Anschluß 2 verbunden, der mit einer Versorgungsspannung V_{DD} von z.B. 5 V beschaltet ist. Die Sourceanschlüsse der n-Kanal-Transistoren T2 und T4 liegen an einem Anschluß 3, der mit dem Bezugspotential V_{SS} beschaltet ist. Die Drainanschlüsse von T1 und T2 sind in einem Knoten 4 miteinander verbunden, die Drainanschlüsse der Transistoren T3 und T4 in einem Knoten 5. Zur Realisierung der Kreuzkopplung sind die miteinander verbundenen Gateanschlüsse von T1 und T2 mit dem Knoten 5 verbunden und die miteinander verbundenen Gateanschlüsse von T3 und T4 mit dem Knoten 4. Die Knoten 4 und 5 sind jeweils über die Source-Drain-Strecken von n-Kanal-Auswahltransistoren T5 und T6 mit Datenleitungen L und L̅ verbunden. Dabei werden die Gates von T5 und T6 über eine Wortleitung WL angesteuert.

Die Speicherzellen sind im Speicherfeld 1 zeilen- und spaltenweise zusammengefaßt, und zwar derart, daß sämtliche Speicherzellen einer Zeile an einer gemeinsamen Wortleitung WL liegen, während sämtliche Speicherzellen einer Spalte ein gemeinsames Datenleitungspaar L, L̅ aufweisen. Die Wortleitungen sämtlicher Zeilen des Speicherfeldes 1 sind in Fig. 1 mit WLᵢ bezeichnet, die Datenleitungspaare L, L̅ sämtlicher Spalten mit Lᵢ, L̅ᵢ. Die Datenleitungspaare Lᵢ, L̅ᵢ sind einerseits mit den Eingängen eines Leseverstärkers 6 und andererseits mit den Ausgängen einer Einschreibschaltung 7 beschaltet. Weiterhin sind sie mit den Ausgängen 8 einer Vorladeschaltung 9 vorbunden, über die sie mit einem vorgegebenen Potential beaufschlagt werden können. Die Vorladeschaltung 9 enthält beispielsweise n-Kanal-Transistoren, deren Sourceanschlüsse die Ausgänge 8 darstellen, wobei ihre Drainanschlüsse mit der Versorgungsspannung V_{DD} beschaltet sind. Die Steueranschlüsse der n-Kanal-Transistoren sind an einen Steuereingang 10 gelegt. Die Ausgänge 11a, 11b des Leseverstärkers 6 sind über einen Zwischenspeicher 12 und einen Pufferverstärker 13 an einen Datenausgang DA geführt, während ein Dateneingang DE über einen Pufferverstärker 14 mit einem Eingang 15 der Einschreibschaltung 7 in Verbindung steht. Ein Block 16 stellt die Zeilendecodierung dar, ein Block 17 die Spaltendecodierung und die Schreib/Lese-Steuerung des Halbleiterspeichers.

Bei einem n-stelligen, das heißt n Bit umfassenden Adreßsignal A sind n Eingänge 16a der Zeilendecodierung 16 über n Leitungen 18 und n Pufferverstärker 19 mit n Eingängen 20 verbunden, sowie n Eingänge 17a von 17 über n Leitungen 21 und die Pufferverstärker 19 ebenfalls mit den Eingängen 20. Die Ausgänge der Zeilendecodierung 16 sind mit den Wortleitungen WLᵢ beschaltet, die Ausgänge der Spaltendecodierung und Schreib/ Lese-Steuerung 17 über Ausgangsleitungen 22 und 23 mit den Schaltungseinheiten 6, 7, 12, 13 und 14. Eine weitere Leitung 21 verbindet einen weiteren Eingang 20, an dem ein Schreib-/Lesesignal RW anliegt, mit einem weiteren Eingang 17a von 17. Schließlich ist noch ein Eingang 20 vorgesehen, dem ein Chip-Select-Signal CS zugeführt wird und der über zusätzliche Leitungen 18 und 21 mit zusätzlichen Eingängen 16a und 17a verbunden ist.

Insgesamt sind also n + 2 Eingänge 20 vorgesehen, die mit den Eingängen von n + 2 gleichartig aufgebauten Signalwechsel-Erkennungsschaltungen 24 verbunden sind, deren gemeinsamer Ausgang 25 mit einem ersten Eingang eines Taktspannungsgenerators 26 beschaltet ist. Ein zweiter Eingang 27 des Taktspannungsgenerators 26 ist mit dem Ausgang 28a einer Steuerschaltung 28 verbunden, deren Eingänge an den Ausgängen 11a und 11b des Leseverstärkers 6 liegen. Ein erster Ausgang 29 von 26 ist mit dem Steuereingang 10 der Vorladeschaltung 9 beschaltet, während ein zweiter Ausgang 30 von 26 über eine Leitung 31 mit einem Eingang der Spaltendecodierung und Schreib/Lese-Steuerung 17 verbunden ist und zusätzlich über eine Leitung 32 mit einem Eingang 16b der Zeilendecodierung 16 verbunden sein kann. Die Ausgangsleitung 22 von 17 ist auch mit einem weiteren Eingang der Steuerschaltung 28 verbunden.

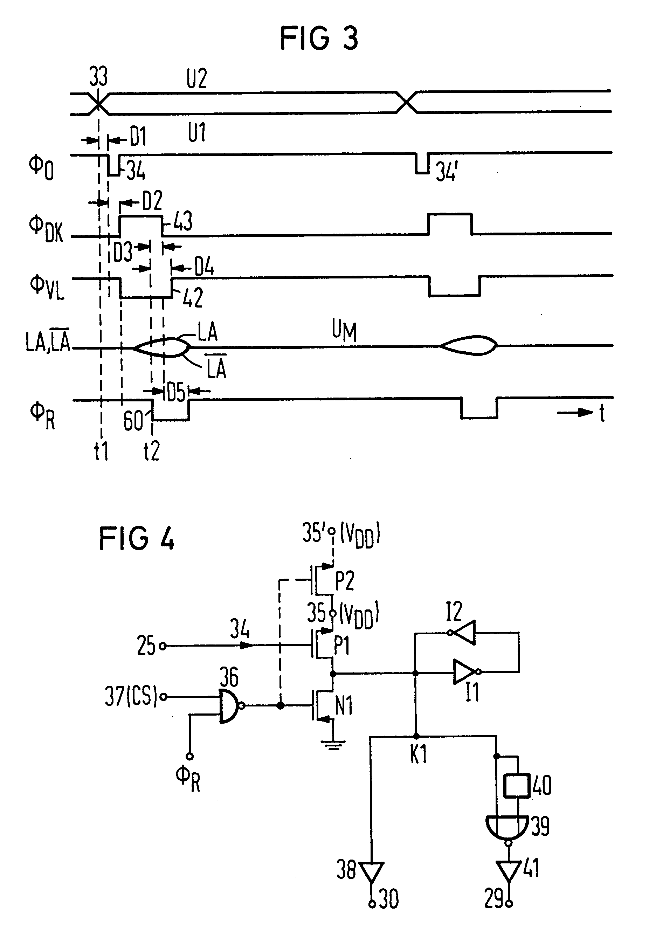

Beim Adressieren einer Speicherzelle, z.B. T1 bis T6, zum Zweck des Auslesens eines in dieser gespeicherten Signals über DA, wird den Eingängen 20 ein entsprechendes Adreßsignal A zugeführt, das sich von dem vorher anliegenden Adreßsignal unterscheidet, so daß ein Adreßsignalwechsel erfolgt. Dieser wird in Fig. 3 durch den Schnittpunkt 33 zweier über der Zeit t aufgetragener Spannungsverläufe dargestellt. Der eine Spannungsverlauf U1 kann dabei ein Bit eines ersten Adreßsignals darstellen, das zum Zeitpunkt t1 von einem oberen Spannungswert, zum Beispiel einer "1", auf einen unteren Spannungswert, Z.B. eine "0", übergeht, während der andere Spannungsverlauf U2 ein Bit eines zweiten Adreßsignals veranschaulicht, das zum Zeitpunkt t1 von "0" auf "1" geht.

Wenigstens eine der Signalwechsel-Erkennungsschaltungen 24 leitet aus dem Adreßsignalwechsel zum Zeitpunkt t1 ein impulsförmiges Ausgangssignal 34 ab, dessen fallende Flanke (Übergang von "1 auf "0") um eine Zeitspanne D1 gegenüber t1 verzögert ist. Der Taktspannungsgenerator gibt an seinem Ausgang 29 vor dem Zeitpunkt t1 eine erste Taktspannung Ø_{VL} ab, die dem Steuereingang 10 der Vorladeschaltung zugeführt wird. Ø_{VL} weist dabei einen Spannungspegel "1" auf, der die Vorladeschaltung 9 aktiviert, so daß die Datenleitungen Lᵢ, L̅ᵢ auf ein vorgegebenes Potential vorgeladen werden. Die fallende Flanke des Ausgangssignals 34 bewirkt nach einer Verzögerungszeit von D2 eine Umschaltung der ersten Taktspannung Ø_{VL} auf einen Spannungspegel "0" und damit eine Deaktivierung der Vorladeschaltung 9, das heißt die Abschaltung der Datenleitungen von einer die Vorladung bewirkenden Spannungsquelle. Gleichzeitig wird eine zweite Taktspannung Ø_{DK}, die am Ausgang 30 auftritt, von einem Spannungspegel "0" auf einen Spannungspegel "1" geschaltet, was zu einer Aktivierung der Spaltendecodierung und Schreib/Lese-Schaltung 17 und, wenn eine interne Taktung der Zeilendecodierung vorgesehen ist, zu einer Aktivierung von 16 führt. Damit ist die gewünschte Speicherzelle adressiert und der Speicherzugriff kann erfolgen. Da es sich hierbei um einen Auslesevorgang handelt, sind neben der Selektion der zu der adressierten Speicherzelle gehörenden Datenleitungen, z.B. L und L̅, auch der Leseverstärker 6 und die Schaltungseinheiten 12 und 13 aktiviert, was mittels des Schreib-/Lesesignals R/W geschieht, das auf einen ersten Spannungspegel umgeschaltet wird, während die Schreibschaltung 7 und der Pufferverstärker 14 deaktiviert bleiben. Die Zeilendecodierung 16 braucht dann nicht mittels der Taktspannung Ø_{DK} aktiviert bzw. deaktiviert zu werden, wenn die einzelnen Speicherzellen so dimensioniert sind, daß die an der zur Vorladung dienenden Spannungsquelle liegenden Datenleitungen zusammen mit einer selektierten Wortleitung nicht zu einer Verfälschung der gespeicherten Signale in den an der selektierten Wortleitung liegenden Speicherzellen führen können.

Die Steuerschaltung 28 wertet das an den Ausgängen 11a und 11b des Leseverstärkers 6 auftretende, gelesene Signal LA, L̅A̅ aus. Sie erkennt, ob eine gewisse Signalamplitude überschritten wird. Ist das der Fall, so geht das Ausgangssignal Ø_{R} der Steuerschaltung 28 von "1" auf "0". Gemäß Fig. 3 tritt dies zum Zeitpunkt t2 auf. Mittels der fallenden Flanke 60 von Ø_{R} wird der Taktspannungsgenerator 26 über seinen Eingang 27 so angesteuert, daß zunächst nach einer Verzögerungszeit D3 die Taktspannung Ø_{DK} von "1" auf "0" geschaltet wird und nach einer D3 übersteigenden Verzögerungszeit D4 die Taktspannung Ø_{VL} wieder von "0" auf "1" zurückgeschaltet wird. Schließlich wird bei Beendigung des Speicherzugriffs, d.h. beim Verschwinden des Ausgangssignals LA, L̅A̅ das Ausgangssignal Ø_{R} von "0" auf "1" umgeschaltet, wodurch der Taktspannungsgenerator 26 für das Erkennen eines neuen Ausgangssignals 34′ der Signalwechsel-Erkennungsschaltung 24 wieder sensibilisiert wird.

Unter der Annahme, daß in der adressierten Speicherzelle T1 bis T6 vor dem Zeitpunkt t1 eine "1" gespeichert war, wobei der Knoten 4 zum Beispiel mit der Versorgungsspannung V_{DD} belegt ist und der Knoten 5 auf Bezugspotential liegt, und unter der weiteren Annahme, daß die Datenleitungen L und L̅ vor t1 etwa auf die halbe Versorgungsspannung V_{DD} vorgeladen worden waren, läuft der Auslesevorgang im einzelnen so ab, daß bei leitend geschalteten Transistoren T5 und T6 die Datenleitung L̅ über den Transistor T6 auf das Bezugspotential entladen wird, während sich die Datenleitung L über den Transistor T5 auf die Versorgungsspannung V_{DD}, verringert um die n-Kanal-Transistoreinsatzspannung Vₜₕ, auflädt. Die Differenz zwischen den sich auf den beiden Datenleitungen L und L̅ einstellenden Potentialen wird im Leseverstärker bewertet. An den Ausgängen 11a und 11b desselben tritt dann das Differenzsignal LA-L̅A̅ auf. Das Signal LA wird in Fig. 3 durch einen den mittleren Signalwert U_{M} überschreitenden Spannungsverlauf angedeutet, L̅A̅ durch einen U_{M} unterschreitenden Spannungsverlauf.

Das Ausgangssignal LA, L̅A̅ gelangt über die Ausgänge 11a, 11b an den Zwischenspeicher 12 und wird über dessen Ausgang und den Pufferverstärker 13 an den Datenausgang DA übertragen. An diesem steht es dann so lange zur Verfügung, bis an den Ausgängen 11a, 11b ein neues Signal auftritt, das seinerseits in den Zwischenspeicher 12 übernommen wird.

Soll in eine Speicherzelle ein Signal eingeschrieben werden, so bewirkt die Zuführung des dieser Speicherzelle zugeordneten Adreßsignals einen Adreßsignalwechsel, der wieder zu einem Ausgangssignal 34 und im zeitlichen Abstand von D2 von dessen fallender Flanke zu einer Deaktivierung der Vorladeschaltung mittels Ø_{VL} sowie zu einer Aktivierung der Blöcke 16 und 17 mittels Ø_{DK} führt. Damit ist diese Speicherzelle adressiert. Weiterhin wird das Signal R/W auf einen zweiten Spannungspegel umgeschaltet, der einen Einschreibvorgang kennzeichnet, so daß auch bei nicht geänderten Adreßsignalen A ein Ausgangssignal 34 der Schaltung 24 erzeugt wird. Durch den zweiten Spannungspegel von R/W werden die Blöcke 6, 7 und 14 aktiviert, während 12 und 13 deaktiviert bleiben. Das einzuschreibende Signal gelangt nun über 14, 15 und 7 auf das selektierte Datenleitungspaar L, L̅ und auf die Eingänge des Leseverstärkers 6, was zur Abgabe eines Ausgangssignals LA, L̅A̅ an den Ausgängen 11a und 11b führt. Die Steuerschaltung 28 wertet dieses Ausgangssignal wieder dadurch aus, daß Ø_{R} von "1" auf "0" geht. Dabei steuert die fallende Flanke 60 den Taktspannungsgenerator 26 so an, daß Ø_{DK} von "1" auf "0" und Ø_{VL} von "0" auf "1" zurückgeschaltet werden. Beim Verschwinden des Ausgangssignals an 11a und 11b wird Ø_{R} von "0" auf "1" umgeschaltet, so daß der Taktspannungsgenerator 26 wieder ein neues Signal 34′ der Schaltung 24 erkennen kann.

Fig. 4 zeigt ein Beispiel eines Taktspannungsgenerators 26 in komplementärer Schaltungstechnik. Das Ausgangssignal 34 der Signalwechsel-Erkennungsschaltung wird hier auf das Gate eines p-Kanal-Transistors P1 geführt, dessen Source über einen Anschluß 35 mit der Versorgungsspannung V_{DD} belegt ist und dessen Drain mit einem internen Knoten K1 verbunden ist. Das Ausgangssignal Ø_{R} der Steuerschaltung 28 ist auf einen ersten Eingang eines NAND-Gatters 36 gelegt, dessen Ausgang mit dem Gate eines n-Kanal-Transistors N1 verbunden ist. Source und Drain von N1 sind an das Bezugspotential V_{SS} bzw. an den internen Knoten K1 angeschlossen. Ein zweiter Eingang 37 des Gates 36 ist zweckmäßigerweise mit einem Signal CS belegt, das als "Chip select"-Signal bezeichnet wird. Nimmt CS den Wert "1" an, so ist der Halbleiterspeicher als solcher aktiviert, während ein Wert "0" die Unwirksamschaltung des Speichers bedeutet. Eine aus den Invertern I1 und I2 bestehende Halteschaltung ist mit dem Knoten K1 verbunden. K1 ist über einen Pufferverstärker 38 mit dem Ausgang 30 beschaltet, an dem die Taktspannung Ø_{DK} zur Verfügung steht. Weiterhin ist K1 direkt mit dem ersten Eingang eines NOR-Gatters 39 und über eine Verzögerungsschaltung 40, z.B. eine Inverterkette, mit einem zweiten Eingang von 39 verbunden. Der Ausgang von 39 ist über einen Pufferverstärker 41 an den Ausgang 29 geführt, an dem die Taktspannung Ø_{VL} abgegriffen wird. Durch die Schaltungsteile 39 und 40 erhält man eine Verzögerung der ansteigenden Flanke 42 von Ø_{VL} gegenüber der abfallende Flanke 43 von Ø_{DK}, die erforderlich ist, um sicherzustellen, daß die Decodierung des Speichers abgeschaltet ist, bevor die Vorladeschaltung 9 eingeschaltet wird.

Der Zustand des Knotens K1 läßt sich über die Transistoren N1 und P1 auf "0" oder "1" setzen. Dabei setzt die fallende Flanke des Ausgangssignals 34 durch Leitendschaltung von P1 den Knoten K1 auf "1". Durch weitere Ausgangssignale 34 wird dieser Zustand dann nicht mehr geändert. Mit dem auf "1" gesetzten Knoten K1 werden Ø_{VL} auf "0" und Ø_{DK} auf "1" gesetzt, so daß die Vorladeschaltung 9 deaktiviert und die Decodierungen 16, 17 aktiviert werden. Andererseits bewirken die Zustände Ø_{R} = 0 (Steuerschaltung erkennt ein Ausgangssignal LA, L̅A̅ des Leseverstärkers 6) oder CS = 0 (Speicher ist nicht mehr aktiviert) die Leitendschaltung von N1 und ein Rücksetzen des Knotens K1 auf "0". Dies hat die Zustände Ø_{DK} = "0" und Ø_{VL} = "1" und somit ein Abschalten der Decodierung und ein Einschalten der Vorladeschaltung 9 zur Folge.

Mit CS = "0" oder Ø_{R} = "0" muß K1 auch bei gleichzeitig eingeschaltetem Transistor T1 sicher in den logischen Zustand "0" gebracht werden. Dies setzt voraus, daß N1 im leitenden Zustand einen wesentlichen kleineren Widerstand zwischen seinem Source- und seinem Drainanschluß aufweist, als der Transistor P1. Weiterhin sind N1 und P1 so zu dimensionieren, daß sie deutlich mehr Strom liefern als der Inverter I2.

In der Schaltung nach Figur 4 tritt bei gleichzeitig leitenden Transistoren P1 und N1 ein Querstrom und damit eine unverwünschte Verlustleistung auf. Um das zu vermeiden, wird zweckmäßigerweise der Anschluß 35 über einen p-Kanal-Transistor P2 mit einem Anschluß 35′ verbunden, der anstelle von 35 mit der Versorgungsspannung V_{DD} beschaltet ist. Das Gate von P2 ist dann mit dem Ausgang des NAND-Gatters 36 verbunden. P2 dient als Schalttransistor, der bei leitend geschaltetem Transistor N1 die Versorgungsspannung V_{DD} vom Anschluß 35 abschaltet. Damit wird das Auftreten eines Querstromes verhindert.

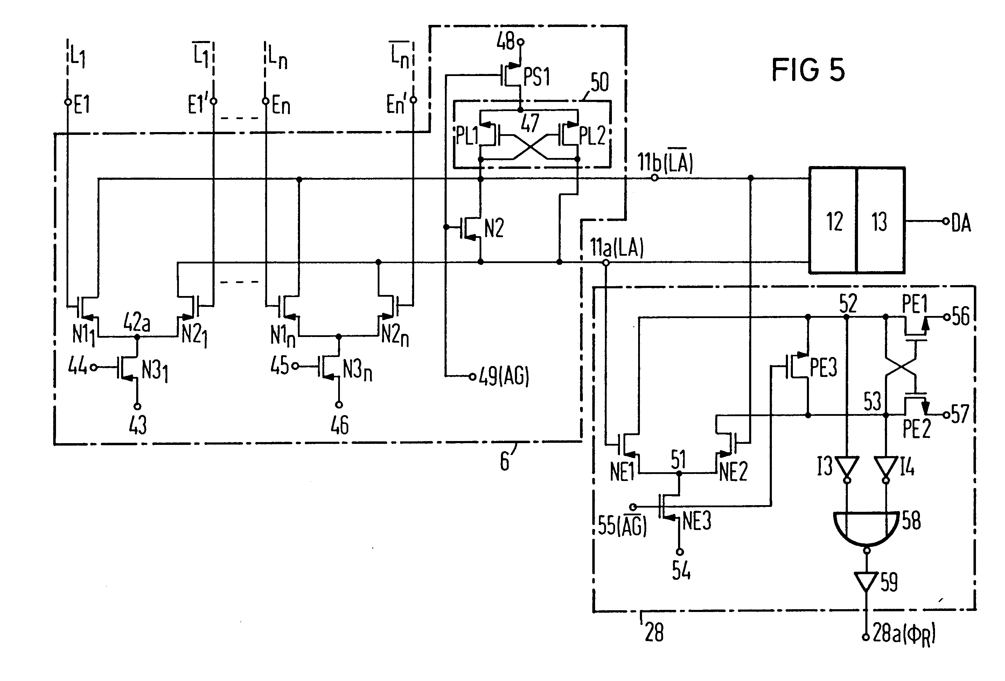

Fig. 5 zeigt eine bevorzugte Ausführungsform der Steuerschaltung 28 und eine zweckmäßige schaltungstechnische Durchbildung des Leseverstärkers 6. Der Leseverstärker 6 weist dabei 2n Datenleitungseingänge auf, von denen die ersten beiden mit E1 und E1′ bezeichnet und mit den Datenleitungen L₁ und L̅₁ der ersten Spalte des Speicherfeldes 1 beschaltet sind. Die Eingänge Eₙ und Eₙ′ sind mit den Datenleitungen Lₙ und L̅ₙ der n-ten Spalte verbunden. Den Eingängen E1 und E1′ sind drei n-Kanal-Transistoren N1₁, N2₁ und N3₁ zugeordnet, von denen die beiden ersten mit ihren Sourceanschlüssen an einem Knoten 42a liegen. Der Drainanschluß von N2₁ ist mit dem Ausgang 11a verbunden, der Drainanschluß von N1₁ mit dem Ausgang 11b. Das Gate von N1₁ ist mit dem Eingang E1 beschaltet, das Gate von N2₁ mit dem Eingang E1′. Der Knoten 42a ist mit dem Drainanschluß des Fußpunkttransistors N3₁ beschaltet, dessen Source über einen Anschluß 43a auf Bezugspotential gelegt ist. Das Gate von N3₁ ist über einen Anschluß 44 mit einem ersten Ausgang der Spaltendecodierung 17 beschaltet, an dem eine "1" anliegt, wenn das Datenleitungspaar L₁, L̅₁ selektiert ist. Den weiteren Datenleitungseingängen des Leseverstärkers 6 sind in analoger Weise n-Kanal-Transistoren zugeordnet, die in entsprechender Weise mit 11a und 11b verbunden sind, wobei die Gateanschlüsse der Fußpunkttransistoren jeweils an den übrigen Ausgängen der Spaltendecodierung 17 liegen. In Fig. 5 sind die den Eingängen Eₙ und Eₙ′ zugeordneten n-Kanal-Transistoren mit N1ₙ, N2ₙ und N3ₙ bezeichnet. Der Gateanschluß des Fußpunkttransistors N3ₙ hat das Bezugszeichen 45, während 46 den auf Bezugspotential liegenden Sourceanschluß von N3ₙ bezeichnet.

Der Ausgang 11b ist mit dem Drainanschluß eines p-Kanal-Transistors PL1 verbunden, dessen Sourceanschluß an einem Knoten 47 liegt. Analog hierzu ist der Ausgang 11a mit dem Drainanschluß eines p-Kanal-Transistors PL2 beschaltet, dessen Sourceanschluß mit dem Knoten 47 verbunden ist. Der Gateanschluß von PL1 ist mit dem Drainanschluß von PL2 beschaltet, der Gateanschluß PL2 von mit dem Drainanschluß von PL1. Der Knoten 47 ist über die Source-Drain-Strecke eines weiteren p-Kanal-Transistors PS1 an einen Anschluß 48 geführt, der mit der Versorgungsspannung V_{DD} beschaltet ist. Weiterhin sind die Ausgänge 11a und 11b über die Source-Drain-Strecke eines n-Kanal-Feldeffekttransistors N2 miteinander verbunden, wobei die Gates von PS1 und N2 an einen Anschluß 49 gelegt sind. Die Transistoren PL1 und PL2 stellen einen p-Kanal-Lastteil 50 des Leseverstärkers 6 dar. An den Ausgängen 11a und 11b sind gemäß Figur 1 ein Zwischenspeicher 12 und ein Pufferverstärker 13 angeschlossen, dessen Ausgang den Datenausgang DA darstellt.

Die in Fig. 5 gezeigte Ausführungsform der Steuerschaltung 28 enthält drei n-Kanal-Transistoren NE1, NE2 und NE3, von denen die beiden ersten mit ihren Sourceanschlüssen an einen Knoten 51 gelegt sind, wobei der Drainanschluß von NE1 an einem Knoten 52 und der Drainanschluß von NE2 an einem Knoten 53 liegen. Der Gateanschluß von NE1 ist mit dem Ausgang 11a verbunden, der Gateanschluß von NE2 mit dem Ausgang 11b. Der Knoten 51 ist über die Source-Drain-Strecke von NE3 mit einem Anschluß 54 verbunden, der auf Bezugspotential V_{SS} liegt. Der Gateanschluß von NE3 ist mit 55 bezeichnet. Der Knoten 52 ist über die Source-Drain-Strecke eines p-Kanal-Transistors PE1 mit einem Anschluß 56 verbunden, der mit der Versorgungsspannung V_{DD} beschaltet ist. Analog hierzu ist der Knoten 53 über die Source-Drain-Strecke eines p-Kanal-Transistors PE2 mit einem Anschluß 57 verbunden, dem ebenfalls die Versorgungsspannung zugeführt wird. Dabei sind das Gate von von PE1 mit dem Drainanschluß von PE2 verbunden und das Gate von PE2 mit dem Drainanschluß von PE1. Die Knoten 52 und 53 sind über die Source-Drain-Strecke eines p-Kanal-Transistors PE3 miteinander verbunden, dessen Gate an den Anschluß 55 gelegt ist. Weiterhin sind die Knoten 52 und 53 über Inverter I3 bzw. I4 an die Eingänge eines NOR-Gatters 58 geführt, dessen Ausgang über einen Pufferverstärker 59 mit dem Ausgang 28a in Verbindung steht.

In der Vorladephase, d.h. mit Ø_{VL} = "1" und Ø_{DK} = "0", sind alle Fußpunkttransistoren N3₁ bis N3ₙ des Leseverstärkers 6 gesperrt. Der Anschluß 49 ist mit einer "1" belegt, so daß die Ausgänge 11a und 11b über den Transistor N2 kurzgeschlossen sind und die Versorgungsspannung V_{DD} über den gesperrten Transistor PS1 abgeschaltet ist. Der Gateanschluß 55 von NE3 ist mit einer "0" belegt, so daß NE3 sperrt und PE3 leitet. Damit liegen die Knoten 52 und 53 jeweils auf dem Potential V_{DD}-Vₜ, wobei Vₜ die Einsatzspannung von PE1 bzw. PE2 bedeutet. Die Inverter I3 und I4 bewerten das Potential an 52 bzw. 53 jeweils als "1", so daß das an 28a abgreifbare Ausgangssignal Ø_{R} ebenfalls "1" ist.

Beim Adressieren einer Speicherzelle wird derjenige Fußpunkttransistor, der zu der selektierten Spalte gehört, leitend geschaltet. Dabei wird das am Anschluß 49 anliegende Signal von "1" auf "0" umgeschaltet. Hierdurch werden die Ausgänge 11a und 11b voneinander entkoppelt, wobei durch die Leitendschaltung von PS1 die Versorgungsspannung V_{DD} an den Knoten 47 angelegt wird. Weiterhin wird das am Gateanschluß 55 anliegende Signal, das zu dem bei 49 anliegenden Signal invertiert ist, von "0" auf "1" umgeschaltet. Damit wird der Transistor NE3 leitend geschaltet, während der Transistor PE3 sperrt. Da sich die Potentiale auf den selektierten Datenleitungen in Abhängigkeit von dem auszulesenden Signal in jeweils entgegengesetzter Richtung ändern, ist das auch an den Ausgängen 11a und 11b des einen Differenzverstärker darstellenden Leseverstärkers 6 der Fall. Die dort auftretenden gegenläufigen Potentialänderungen sind in Fig. 3 als LA und L̅A̅ bezeichnet. Da in Abhängigkeit von dem auszulesenden Signal entweder LA oder L̅A̅ sich in Richtung auf das Bezugspotential verändert und eine entsprechende Potentialänderung auch am Knoten 52 oder 53 auftritt, wird die Ansprechschwelle eines der Inverter I3 oder I4 hierdurch unterschritten. Der betreffende Inverter erkennt damit ein Eingangssignal "0" und legt eine "1" an den ihm nachgeordneten Eingang des NOR-Gatters 58. Dabei wird das am Ausgang 28a auftretende Signal Ø_{R} von "1" auf "0" umgeschaltet. Diese Umschaltung, die in Fig. 3 durch die fallende Flanke 60 von Ø_{R} angedeutet ist, bewirkt, daß nach dem Ablauf der Verzögerungszeit D3 der Transistor N1 leitend geschaltet wird, so daß der Knoten K1 (Fig. 4) auf "0" gesetzt wird und damit Ø_{DK} abgeschaltet wird, was weiterhin die Sperrung des dem selektierten Datenleitungspaar zugeordneten Fußpunkttransistors des Leseverstärkers 6 zur Folge hat. In Abhängigkeit von der fallenden Flanke 60 wird andererseits nach dem Ablauf der Verzögerungszeit D4 die Taktspannung Ø_{VL} wieder eingeschaltet. Nach dem Ablauf von D3 werden außerdem die Transistoren N2 und PE3 leitend geschaltet, so daß die Potentialdifferenz an den Ausgängen 11a und 11b sowie an den Knoten 52 und 53 verschwindet. Die Potentiale an 52 und 53 stellen sich auf den Wert V_{DD}- Vₜ ein, wodurch beide Inverter I3 und I4 ihre Eingangssignale wieder als "1" bewerten und Ø_{R} auf "1" umgeschaltet wird. Durch diesen Umschaltvorgang wird das NAND-Gatter 36 auf ein Ausgangssignal "0" gesetzt, was zur Sperrung von N1 führt, wobei jedoch den Knoten K1 auf "0" verbleibt, so lange P1 ebenfalls gesperrt ist. Hierdurch ist der Taktspannungsgenerator 26 für das nächstfolgende Ausgangssignal 34 wieder sensibilisiert, da durch die fallende Flanke desselben eine Leitendschaltung von P1 erfolgt, wodurch K1 auf "1" gesetzt wird. Wird der Schalttransistor PS1 in einem im übrigen nach Fig. 5 aufgebauten Leseverstärker 6 weggelassen, so können auch die Schaltungsteile NE1 bis NE3, PE1 bis PE3, 52, 53, 56 und 57 der Steuerschaltung 28 entfallen. Der Eingang von I3 ist in diesem Fall direkt an den Ausgang 11a angeschlossen, der Eingang von I4 direkt an 11b.

Der Lasttteil 50 des Leseverstärkers 6 kann in Abweichung von Fig. 5 auch so ausgebildet sein, daß die Gates von PL1 und PL2 miteinander verbunden und an den Drainanschluß von PL1 gelegt sind. Andererseits können die Gates von PL1 und PL2 auch miteinander verbunden und an einen Referenzspannungsanschluß geführt sein. In diesem Fall ist jedoch die im vorstehenden Absatz beschriebene Vereinfachung der Steuerschaltung 28 nicht zulässig.

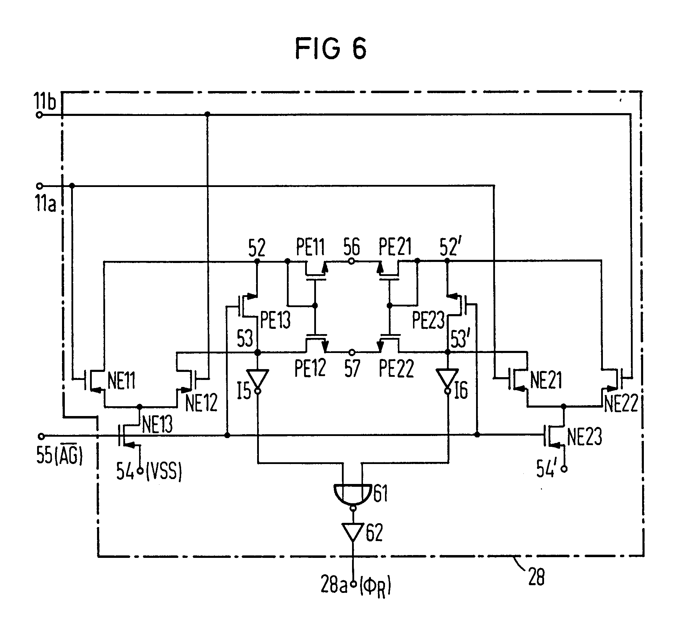

Fig. 6 zeigt eine weitere Ausführung der Steuerschaltung 28, bei der eine bistabile Schaltungsauslegung, wie sie durch die kreuzgekoppelten Transistoren PE1 und PE2 in Fig. 5 gegeben ist, vermieden wird. Eine erste Differenzverstärkerschaltung, die im Aufbau der in Fig. 5 dargestellten weitgehend entspricht, ist im linken Teil von Fig. 6 dargestellt. Dabei entsprechen die n-Kanal-Transistoren NE11 bis NE13 und die p-Kanal-Transistoren PE11 bis PE13 den Schaltungsteilen NE1 bis NE3 und PE1 bis PE3 in Fig. 5, wobei der Unterschied vorhanden ist, daß die Gateanschlüsse von PE11 und PE12 mit dem Drainanschluß von PE11 verbunden sind. Ein weiterer Unterschied besteht darin, daß der Knoten 53 mit einem Invertereingang verbunden ist, der Knoten 52 jedoch nicht mehr über einen Invertereingang abgegriffen wird. Eine zweite Differenzverstärkerschaltung, die der ersten im Aufbau vollständig entspricht, bildet den rechten Teil der Schaltung nach Fig. 6. Sie enthält n-Kanal-Transistoren NE21 bis NE23 und p-Kanal-Transistoren PE21 bis PE23 in einer dem linken Teil von Fig. 6 entsprechenden Schaltungskonfiguration. Der Gateanschluß von NE21 ist mit dem Ausgang 11a verbunden, der Gateanschluß von NE22 mit dem Ausgang 11b. Weiterhin ist der auf Bezugspotential V_{SS} liegende Sourceanschluß von NE23 mit 54′ bezeichnet. Die Drainanschlüsse von PE21 und PE22 sind mit 52′ und 53′ bezeichnet. Auch hier ist nur der Knoten 53′ mit einem Invertereingang beschaltet, der Knoten 52′ dagegen nicht. Die Eingänge zweier Inverter I5 und I6, die den Invertern I3 und I4 von Fig. 5 entsprechen, sind nach Fig. 6 mit den Knoten 53 und 53′ verbunden. Die Ausgänge von I5 und I6 liegen an den Eingängen eines NOR-Gatters 61, dessen Ausgang über einen Pufferverstärker 62 an den Ausgang 28a gelegt ist.

Nach Fig. 6 erfolgt eine Vorladung der Knoten 52 und 53 sowie 52′ und 53′ auf ein Potential V_{DD}-Vₜ, wobei Vₜ wieder die Einsatzsspannung der Transistoren PE11 oder PE12 bzw. PE21 oder PE22 bedeutet. Beim Auslesen einer Speicherzelle sinkt das Potential in Abhängigkeit von dem gespeicherten Signal entweder am Ausgang 11a oder 11b des Leseverstärkers und dementsprechend auch am Knoten 53 oder 53′, wobei entweder I5 oder I6 die Potentialverringerung als ein Eingangssignal "0" erkennt und dem nachgeordneten Eingang des NOR-Gatters 61 eine "1" zuführt, was zur Umschaltung des Signals Ø_{R} am Ausgang 28 von "1" auf "0" führt. Beim Anlegen einer "1" an den Anschluß 55 werden die Potentiale an den Knoten 53 und 53′ über die leitenden Transistoren PE13 und PE23 wieder auf den Vorladewert V_{DD}-Vₜ gebracht, so daß Ø_{R} auf den Wert "1" umgeschaltet wird.

Die Anschlüsse 49 und 55 des Leseverstärkers 6 bzw. der Steuerschaltung 28 in Fig. 5 und Fig. 6 sind mit Signalen AG bzw. A̅G̅ beschaltet, das von der Spaltendekodierung und Schreib/Lese-Steuerung 17 aus der Taktspannung Ø_{DK} abgeleitet und über die Ausgangsleitungen 22 zugeführt wird. Diese Signale sind "1" bzw. "0" bei aktivierter Schaltung 17, das heißt bei Ø_{DK} = "1", und aktivieren damit die Blöcke 6 und 28. Andererseits sind diese Signale "0" bzw. "1" bei deaktivierter Schaltung 17, das heißt bei Ø_{DK} = "0", und deaktivieren damit die Blöcke 6 und 28.

Bei einer Ausführungsform der Steuerschaltung nach Figur 5 können Störungen oder fertigungsbedingte Unsymmetrien zwischen den Transistoren NE1 und NE2 oder PE1 und PE2 dazu führen, daß die Schaltung einen ihrer beiden stabilen Zustände einnimmt, ohne daß ein Signalhub an den Schaltungspunkten 11a und 11b auftritt. Diese Gefahr besteht allerdings nur dann, wenn der Transistor PE3 bereits längere Zeit vor dem Auftreten eines Signalhubs an 11a und 11b gesperrt wird. Bei der Schaltung nach Fig. 6 ist diese Gefahr vollständig ausgeschaltet.

Der Aufbau einer Signalwechsel-Erkennungsschaltung 24 ist beispielsweise aus IEEE Journ. of Solid-State Circuits, Vol. SC-19, Okt. 1984, S. 545-551, bekannt. Um nicht nur einen Adreßsignalwechsel, sondern auch einen Wechsel des dem Speicher zugeführten Schreib/Lese-Signals R/W oder des CS-Signals, wenn das letztere von "0" auf "1" umgeschaltet wird, zur Ableitung eines Ausgangssignal 34 heranzuziehen, sind gleichzeitig aufgebaute Schaltungen 24 jedem der n + 2 Eingänge 20 nachgeschaltet.

In Abweichung von den bisher anhand von Fig. 5 beschriebenen Ausführungsformen des Leseverstärkers 6 können die Eingänge Eᵢ, Eᵢ′ statt mit den Datenleitungen Lᵢ,‾Lᵢ auch mit den Ausgängen einer vorgeschalteten Verstärkerstufe beschaltet sein, die ihrerseits mit den genannten Datenleitungen beschaltet ist. Andererseits kann der in Fig. 5 dargestellte Leseverstärker 6 insofern vereinfacht werden, als nur eine n-Kanal-Transistorschaltung, z.B. die mit den Transistoren N1₁ bis N3₁, vorgesehen ist, sofern die Selektion des gewünschten Datenleitungspaares schon vor dem Eingang, z.B. E1 und E1′, des verbleibenden einstufigen Leseverstärkers vorgenommen wird, z.B. in den vorgeschalteten Verstärkerstufen.

Die Schaltschwellen der Inverter I3 bis I6 können in an sich bekannter Weise durch das Verhältnis der Kanalweiten der in ihnen enthaltenen p- und n-Kanal-Transistoren auf einen relativ niedrigen Wert von z.B. 1,5 V eingestellt werden, wenn die Versorgungsspannung V_{DD} etwa 5 V beträgt. Hierdurch wird erreicht, daß das Vorladungspotential an den Knoten 52, 53 und 53′, das um die Einsatzspannung Vₜ niedriger ist als V_{DD}, von den Invertern noch sicher als ein Eingangssignal "1" erkannt wird.

Vorzugsweise kann zwischen dem Ausgang des Pufferverstärkers 19 und den Eingängen 16a und 17a der Zeilendecodierung 16 und der Spaltendecodierung 17 eine Torschaltung 19a vorgesehen sein, die mittels Ø_{DK} derart angesteuert wird, daß sie während eines Speicherzugriffs sperrt. Hierdurch wird verhindert, daß während des Speicherzugriffs weitere Adreßsignale zu den Decodierern 16 und 17 gelangen.

Neben den oben beschriebenen Ausführungsformen der Erfindung sind noch weitere von Bedeutung, bei denen die Wortbreite des Speichers größer ist als 1 Bit. Hierbei sind bei einer Wortbreite von m Bit jeweils m Speicherfelder 1, Vorladeschaltungen 9, Leseverstärker 6, Schreibschaltungen 7, Zwischenspeicher 12, Pufferverstärker 13, 14 und Datenaus- bzw. -eingänge DA, DE vorgesehen. Die Ausgänge der Blöcke 16 und 17 sind dann jeweils mit m einander entsprechenden Wort- und Datenleitungen bzw. Leseverstärkern, Schreibschaltungen, Zwischenspeichern und Pufferverstärkern verbunden. Dabei wird jedoch die Steuerschaltung 28 zweckmäßigerweise nur an die Ausgänge 11a und 11b eines der m Leseverstärker angeschlossen.

## Patentansprüche

1. Halbleiterspeicher mit einer Vielzahl von Speicherzellen, die über Datenleitungen (Lᵢ, L̅ᵢ̅) wahlweise mit einer Schreibschaltung (7) oder einem Leseverstärker (6) und über die letzteren mit einem Dateneingang (DE) oder -ausgang (DA) verbindbar sind, bei dem eine aktivierbare Vorladeschaltung (9) vorgesehen ist, die im aktivierten Zustand die Datenleitungen auf ein vorgegebenes Potential auflädt, bei dem eine Signalwechsel-Erkennungsschaltung (24) vorhanden ist, die die Vorladeschaltung (9) beim Auftreten eines Signalwechsels deaktiviert, und bei dem die Vorladeschaltung (9) zeitverzögert nach dem Auftreten des Signalwechsels wieder aktiviert wird, **dadurch gekennzeichnet,** daß ein Taktspannungsgenerator (26) vorgesehen ist, der eine erste, die Vorladeschaltung ansteuernde Taktspannung erzeugt und der von der Signalwechsel-Erkennungsschaltung (24) so beeinflußt wird, daß er die erste Taktspannung beim Auftreten eines Signalwechsels auf einen ersten Spannungspegel umschaltet, der die Vorladeschaltung (9) deaktiviert, und daß der Leseverstärker (6) mit einer Steuerschaltung (28) verbunden ist, die den Taktspannungsgenerator (26) in Abhängigkeit vom Auftreten eines Ausgangssignals am Leseverstärker (6) so beeinflußt, daß die erste Taktspannung auf einen zweiten Spannungspegel umgeschaltet wird, der die Vorladeschaltung (9) aktiviert.

2. Halbleiterspeicher nach Anspruch 1, **dadurch gekennzeichnet,** daß die Steuerschaltung (28) bei einer Abschaltung des Ausgangssignals des Lesever stärkers (6) den Taktspannungsgenerator (26) für die Ansteuerung durch die Signalwechsel-Erkennungsschaltung (24) sensibilisiert.

3. Halbleiterspeicher nach Anspruch 1 oder 2, **dadurch gekennzeichnet,** daß der Taktspannungsgenerator (26) eine zweite Taktspannung zum Aktivieren einer Spaltendecodierung (17) erzeugt, die gleichzeitig mit der Umschaltung der ersten Taktspannung auf den ersten Spannungspegel auf einen zweiten Spannungspegel umgeschaltet wird, der die Spaltendecodierung (17) aktiviert, und daß die zweite Taktspannung vor der Umschaltung der ersten Taktspannung auf den zweiten Spannungspegel auf einen ersten Spannungspegel umgeschaltet wird, der die Spaltendecodierung (17) deaktiviert.

4. Halbleiterspeicher nach Anspruch 3, **dadurch gekennzeichnet,** daß die zweite Taktspannung mit ihrem zweiten Spannungspegel zusätzlich zur Aktivierung einer Zeilendecodierung (16) dient.

5. Halbleiterspeicher nach einem der vorhergehenden Ansprüche, **dadurch gekennzeichnet,** daß eine Schreib-/Lesesteuerung (17) vorgesehen ist, die bei einem Auslesevorgang den Leseverstärker (6) und einen diesem nachgeschalteten Zwischenspeicher (12) aktiviert und bei einem Einschreibvorgang den Leseverstärker (6) zusammen mit der Schreibschaltung (7) aktiviert, ohne jedoch den Zwischenspeicher (12) zu aktivieren.

6. Halbleiterspeicher nach Anspruch 4, **dadurch gekennzeichnet,** daß den mit den Adreßsignalen beaufschlagten Eingängen der Zeilendecodierung (16) und Spaltendecodierung (17) eine Torschaltung (19a) vorgeschaltet ist, die mittels der zweiten Taktspannung so angesteuert wird, daß sie während des Auftretens des zweiten Spannungspegels derselben sperrt.

7. Halbleiterspeicher nach einem der Ansprüche 1 bis 6, **dadurch gekennzeichnet,** daß der Taktspannungsgenerator (26) zwei Feldeffekttransistoren (P1, N1) unterschiedlicher Kanaltypen enthält, deren Drainanschlüsse mit einem ersten Knoten (K1) verbunden sind, wobei der Sourceanschluß des ersten Feldeffekttransistors (P1) mit der Versorgungsspannung (V_{DD}) beschaltet ist und der Sourceanschluß des zweiten (N1) auf Bezugspotential (V_{SS}) liegt, daß der Gateanschluß des ersten Feldeffekttransistors (P1) einen mit der Signalwechsel-Erkennungsschaltung verbundenen Eingang des Taktspannungsgenerators (26) darstellt, daß der Gateanschluß des zweiten Feldeffekttransistors (N1) einem mit der Steuerschaltung (28) verbundenen Eingang (27) des Taktspannungsgenerators darstellt, daß der erste Knoten (K1) mit dem ersten Eingang eines NOR-Gatters (39) direkt und mit dem zweiten Eingang desselben über eine Verzögerungsschaltung (40) verbunden ist und daß der erste Ausgang (29) des Taktspannungsgenerators mit dem Ausgang des NOR-Gatters (39) und der zweite Ausgang (30) des Taktspannungsgenerators mit dem ersten Knoten (K1) in Verbindung steht.

8. Halbleiterspeicher nach Anspruch 7, **dadurch gekennzeichnet,** daß der Gateanschluß des zweiten Feldeffekttransistors (N1) mit dem Ausgang eines NAND-Gatters (36) beschaltet ist, dessen erster Eingang den mit der Steuerschaltung (28) verbundenen Eingang (27) des Taktspannungsgenerators darstellt und dessen zweiter Eingang (37) mit einem Chip-Selekt-Signal beaufschlagt ist.

9. Halbleiterspeicher nach einem der Ansprüche 7 oder 8, **dadurch gekennzeichnet,** daß der Gateanschluß des zweiten Feldeffekttransistors (N1) mit dem Gateanschluß eines dritten Feldeffekttransistors (P2) verbunden ist, der dem gleichen Kanaltyp wie der erste angehört und mit seiner Source-Drain-Strecke zwischen dem Sourceanschluß des ersten Feldeffekttransistors (P1) und einem mit der Versorgungsspannung beaufschlagten Anschluß (35′) eingefügt ist.

10. Halbleiterspeicher nach einem der Ansprüche 7 bis 9, **dadurch gekennzeichnet,** daß der erste Knoten (K1) mit einer aus zwei kreuzgekoppelten Invertern (I1, I2) bestehenden Halteschaltung verbunden ist.

11. Halbleiterspeicher nach einem der vorhergehenden Ansprüche, **dadurch gekennzeichnet,** daß die Steuerschaltung (28) drei Feldeffekttransistoren eines ersten Kanaltyps (NE1 bis NE3) enthält, von denen zwei über ihre Gateanschlüsse mit zwei Ausgängen (11a, 11b) des Leseverstärkers (6) beschaltet sind, daß diese beiden Feldeffekttransistoren (NE1, NE2) über ihre Drainanschlüsse mit zwei Schaltungsknoten (52, 53) und über ihre Sourceanschlüsse mit dem Drainanschluß des dritten Feldeffekttransistors (NE3) verbunden sind, der mit seinem Sourceanschluß auf Bezugspotential gelegt ist und mit seinem Gateanschluß an einem Steuereingang (55) liegt, daß die beiden Schaltungsknoten (52, 53) über die Source-Drain-Strecken jeweils eines weiteren Feldeffekttransistors (PE1, PE2) des zweiten Kanaltyps mit Anschlüssen (56, 57) verbunden sind, die mit der Versorgungsspannung beschaltet sind, wobei jeweils der Gateanschluß des einen dieser weiteren Feldeffekttransistoren an den Drainanschluß des anderen geführt ist, und daß die beiden Schaltungsknoten (52, 53) einerseits über einen Ausgleichstransistor (PE3), dessen Gate an dem Steuereingang (55) liegt, miteinander und über jeweils einen Inverter (I3, I4) mit den Eingängen eines NOR-Gatters (58) verbunden sind, dessen Ausgang an den Ausgang (28a) der Steuerschaltung (28) geführt ist.

12. Halbleiterspeicher nach einem der Ansprüche 1 bis 10, **dadurch gekennzeichnet,** daß die Steuerschaltung (28) aus zwei an die Ausgänge (11a, 11b) des Leseverstärkers (6) geschalteten Invertern (I3, I4) besteht, deren Ausgänge an die Eingänge eines NOR-Gatters (58) gelegt sind, und daß der Ausgang des NOR-Gatters mit dem Ausgang der Steuerschaltung (28) verbunden ist.

13. Halbleiterspeicher nach einem der Ansprüche 1 bis 10, **dadurch gekennzeichnet,** daß die Steuerschaltung (28) drei Feldeffekttransistoren des ersten Kanaltyps (NE11 bis NE13) enthält, von denen zwei über ihre Gateanschlüsse mit zwei Ausgängen (11a, 11b) des Leseverstärkers (6) beschaltet sind, daß der eine dieser beiden Feldeffekttransistoren (NE11) über seinen Drainanschluß mit einem ersten internen Schaltungsknoten (52) und der andere (NE12) über seinen Drainanschluß mit einem ersten Ausgangsknoten (53) verbunden ist, daß diese beiden Feldeffekttransistoren über ihre Sourceanschlüsse mit dem Drainanschluß des dritten Feldeffekttransistors (NE13) verbunden sind, der mit seinem Sourceanschluß auf Bezugspotential gelegt ist und mit seinem Gateanschluß an einem Steuereingang (55) liegt, daß der erste interne Knoten (52) und der erste Ausgangsknoten (53) einerseits über einen ersten Ausgleichstransistor (PE13) miteinander und über die Source-Drain-Strecken jeweils eines zusätzlichen Feldeffekttransistors (PE11, PE12) des zweiten Kanaltyps mit Anschlüssen (56, 57) verbunden sind, die mit der Versorgungsspannung beaufschlagt sind, wobei die Gateanschlüsse beider zusätzlicher Feldeffekttransistoren mit dem Drainanschluß des einen von ihnen verbunden sind, daß drei zusätzliche Feldeffekttransistoren (NE21 bis NE23) des ersten Kanaltyps vorgesehen sind, die mit Ausnahme der Drainanschlüsse der ersten beiden Feldeffekttransistoren (NE21, NE22) entsprechend den drei Feldeffekttransistoren des ersten Kanaltyps beschaltet sind, daß der Drainanschluß des ersten zusätzlichen Feldeffekttransistors (NE22) mit einem zweiten internen Schaltungsknoten (52′) und der Drainanschluß des zweiten zusätzlichen Feldeffekttransistors (NE21) mit einem zweiten Ausgangsknoten (53′) verbunden sind, daß der zweite interne Knoten (52′) und der zweite Ausgangsknoten (53′) einerseits über einen zweiten Ausgleichstransistor (PE23) miteinander und über die Source-Drain-Strecken jeweils eines weiteren zusätzlichen Feldeffektransistors (PE21, PE22) mit den Anschlüssen (56, 57) verbunden sind, die mit der Versorgungsspannung beaufschlagt sind, wobei die Gateanschlüsse der weiteren zusätzlichen Feldeffekttransistoren mit dem Drainanschluß eines von ihnen verbunden sind, daß die Gateanschlüsse des ersten und zweiten Ausgleichstransistors (PE 13, PE 23) mit dem Steuereingang (55) verbunden sind und daß der erste und der zweite Ausgangsknoten (53, 53′) über jeweils einen Inverter (I5, I6) an die Eingänge eines NOR-Gatters (61) gelegt sind, dessen Ausgang mit dem Ausgang (28a) der Steuerschaltung (28) verbunden ist.

## Claims

1. Semiconductor memory having a plurality of memory cells which can be connected via data lines (Lᵢ, L̅ᵢ̅) either to a write circuit (7) or to a read amplifier (6), and via the latter to a data input (DE) or data output (DA), in which an activatable precharging circuit (9) is provided which in the activated state charges the data lines to a predetermined potential, in which a signal change detector circuit (24) is present which deactivates the precharging circuit (9) when a signal change occurs, and in which the precharging circuit (9) is reactivated with a time delay after the signal change occurs, characterised in that a clock voltage generator (26) is provided which generates a first clock voltage which drives the precharging circuit and which is influenced by the signal change detector circuit (24) in such a way that when a signal change occurs it switches over the first clock voltage to a first voltage level which deactivates the precharging circuit (9), and in that the read amplifier (6) is connected to a control circuit (28) which influences the clock voltage generator (26) depending on the occurrence of an output signal at the read amplifier (6) in such a way that the first clock voltage is switched over to a second voltage level which activates the precharging circuit (9).

2. Semiconductor memory according to Claim 1, characterised in that the control circuit (28) sensitises the clock voltage generator (26) for driving by the signal change detector circuit (24) when the output signal of the read amplifier (6) is disconnected.

3. Semiconductor memory according to Claim 1 or 2, characterised in that the clock voltage generator (26) generates a second clock voltage for activating a column decoding means (17) which is switched over to a second voltage level, which activates the column decoding means (17), simultaneously with the switchover of the first clock voltage to the first voltage level, and in that the second clock voltage is switched over to a first voltage level, which deactivates the column decoding means (17), before the switchover of the first clock voltage to the second voltage level.

4. Semiconductor memory according to Claim 3, characterised in that the second clock voltage additionally serves to activate a row decoding means (16) with its second voltage level.

5. Semiconductor memory according to one of the preceding claims, characterised in that a read/write controller (17) is provided, which activates the read amplifier (6) and an intermediate memory (12) connected downstream thereof for a read operation, and activates the read amplifier (6) together with the write circuit (7), but without the intermediate memory (12), for a write operation.

6. Semiconductor memory according to Claim 4, characterised in that connected upstream of the inputs of the row decoding means (16) and column decoding means (17) which receive the address signals is a gate circuit (19a) which is driven by means of the second clock voltage in such a way that it inhibits said inputs during the occurrence of the second voltage level.

7. Semiconductor memory according to one of Claims 1 to 6, characterised in that the clock voltage generator (26) contains two field-effect transistors (P1, N1) of different channel types, the drain terminals of which are connected to a first node (K1), the source terminal of the first field-effect transistor (P1) being connected to the supply voltage (V_{DD}) and the source terminal of the second (N1) being connected to reference potential (V_{SS}), in that the gate terminal of the first field-effect transistor (P1) represents an input of the clock voltage generator (26) that is connected to the signal change detector circuit, in that the gate terminal of the second field-effect transistor (N1) represents an input (27) of the clock voltage generator that is connected to the control circuit (28), in that the first node (K1) is connected directly to the first input of a NOR gate (39) and to the second input thereof via a delay circuit (40), and in that the first output (29) of the clock voltage generator is connected to the output of the NOR gate (39) and the second output (30) of the clock voltage generator is connected to the first node (K1).

8. Semiconductor memory according to Claim 7, characterised in that the gate terminal of the second field-effect transistor (N1) is connected to the output of a NAND gate (36), the first input of which represents the input (27) of the clock voltage generator that is connected to the control circuit (28), and the second input (37) of which receives a chip select signal.

9. Semiconductor memory according to one of Claims 7 or 8, characterised in that the gate terminal of the second field-effect transistor (N1) is connected to the gate terminal of a third field-effect transistor (P2), which is of the same channel type as the first and is inserted with its source-drain path between the source terminal of the first field-effect transistor (P1) and a terminal (35') that receives the supply voltage.

10. Semiconductor memory according to one of Claims 7 to 9, characterised in that the first node (K1) is connected to a hold circuit comprising two cross-coupled inverters (I1, I2).

11. Semiconductor memory according to one of the preceding claims, characterised in that the control circuit (28) contains three field-effect transistors of a first channel type (NE1 to NE3), two of which are connected via their gate terminals to two outputs (11a, 11b) of the read amplifier (6), in that said two field-effect transistors (NE1, NE2) are connected via their drain terminals to two circuit nodes (52, 53) and via their source terminals to the drain terminal of the third field-effect transistor (NE3), which is connected with its source terminal to reference potential and is connected with its gate terminal to a control input (55), in that the two circuit nodes (52, 53) are connected via the source-drain paths of in each case one further field-effect transistor (PE1, PE2) of the second channel type to terminals (56, 57) which are connected to the supply voltage, the gate terminal of one of said further field-effect transistors being connected to the drain terminal of the other one in each case, and in that the two circuit nodes (52, 53) are connected on the one hand to one another via a compensation transistor (PE3), the gate of which is connected to the control input (55), and via an inverter (I3, I4) in each case to the inputs of a NOR gate (58), the output of which is connected to the output (28a) of the control circuit (28).

12. Semiconductor memory according to one of Claims 1 to 10, characterised in that the control circuit (28) comprises two inverters (I3, I4) connected to the outputs (11a, 11b) of the read amplifier (6), the outputs of which inverters are applied to the inputs of a NOR gate (58), and in that the output of the NOR gate is connected to the output of the control circuit (28).

13. Semiconductor memory according to one of Claims 1 to 10, characterised in that the control circuit (28) contains three field-effect transistors of the first channel type (NE11 to NE13), two of which are connected via their gate terminals to two outputs (11a, 11b) of the read amplifier (6), in that one of said two field-effect transistors (NE11) is connected via its drain terminal to a first internal circuit node (52) and the other (NE12) is connected via its drain terminal to a first output node (53), in that said two field-effect transistors are connected via their source terminals to the drain terminal of the third field-effect transistor (NE13), which is connected with its source terminal to reference potential and is connected with its gate terminal to a control input (55), in that the first internal node (52) and the first output node (53) are connected on the one hand to one another via a first compensation transistor (PE13), and via the source-drain paths of in each case one additional field-effect transistor (PE11, PE12) of the second channel type to terminals (56, 57) which receive the supply voltage, the gate terminals of the two additional field-effect transistors being connected to the drain terminal of one of them, in that three additional field-effect transistors (NE21 to NE23) of the first channel type are provided, which are connected, with the exception of the drain terminals of the first two field-effect transistors (NE21, NE22), in accordance with the three field-effect transistors of the first channel type, in that the drain terminal of the first additional field-effect transistor (NE22) is connected to a second internal circuit node (52') and the drain terminal of the second additional field-effect transistor (NE21) is connected to a second output node (53'), in that the second internal node (52') and the second output node (53') are connected on the one hand to one another via a second compensation transistor (PE23) and via the source-drain paths of in each case one further additional field-effect transistor (PE21, PE22) to the terminals (56, 57) which receive the supply voltage, the gate terminals of the further additional field-effect transistors being connected to the drain terminal of one of them, in that the gate terminals of the first and the second compensation transistor (PE13, PE23) are connected to the control input (55), and in that the first and the second output nodes (53, 53') are connected via an inverter (I5, I6) in each case to the inputs of a NOR gate (61), the output of which is connected to the output (28a) of the control circuit (28).

## Revendications

1. Mémoire à semiconducteurs comportant une multiplicité de cellules de mémoire, qui peuvent être raccordées par l'intermédiaire de lignes de transmission de données (Lᵢ, L̅ᵢ̅) au choix à un circuit d'enregistrement (7) ou à un amplificateur de lecture (6) et, par l'intermédiaire de ces derniers, à une entrée de données (DE) ou à une sortie de données (DA), et dans laquelle il est prévu un circuit de précharge (9) pouvant être activé et qui, à l'état activé, charge des lignes de transmission de données à un potentiel prédéterminé, et dans lequel il est prévu un circuit (4) d'identification de changement de signaux, qui désactive le circuit de précharge (9), lors de l'apparition d'un changement de signal, et dans lequel le circuit de précharge (9) est réactivé, d'une manière retardée, après l'apparition du changement de signal, caractérisée par le fait qu'il est prévu un générateur de tension de cadence (26), qui produit une première tension de cadence qui commande le circuit de précharge et est influencé par le circuit (24) d'identification de changement de signal de telle sorte que, lors de l'apparition d'un changement de signal, il commute la première tension de cadence sur un premier niveau de tension, qui désactive le circuit de précharge (9), et que l'amplificateur de lecture (6) est raccordé à un circuit de commande (28) qui influence le générateur de tension de cadence (26) en fonction de l'apparition du signal de sortie de l'amplificateur de lecture (6) de telle sorte que la première tension de cadence est commutée sur un second niveau de tension qui active le circuit de précharge (9).

2. Mémoire à semiconducteurs suivant la revendication 1, caractérisée par le fait que lors de l'interruption du signal de sortie de l'amplificateur de lecture (6), le circuit de commande (28) sensibilise le générateur de tension de cadence (26) pour la commande par le circuit (24) d'identification du changement de signal.

3. Mémoire à semiconducteurs suivant la revendication 1 ou 2, caractérisée par le fait que le générateur de tension de cadence (26) produit une seconde tension de cadence servant à activer un circuit de décodage de colonnes (17) et qui, en même temps que se produit la commutation de la première tension de cadence sur le premier niveau de tension, est commutée sur un second niveau de tension, qui active le circuit de décodage de colonnes (17), et qu'avant la commutation de la première tension de cadence sur le second niveau de tension, la seconde tension de cadence est conmutée sur un premier niveau de tension, qui désactive le circuit de codage de colonnes (17).

4. Mémoire à semiconducteurs suivant la revendication 3, caractérisée par le fait qu'avec son second niveau, la seconde tension de cadence est utilisée en supplément pour activer un circuit de décodage de lignes (16).

5. Mémoire à semiconducteurs suivant l'une des revendications précédentes, caractérisée par le fait qu'il est prévu un circuit d'enregistrement/lecture (17), qui lors d'une opération de lecture, active l'amplificateur de lecture (6) et une mémoire intermédiaire (12) branchée en aval de cet amplificateur, et, lors d'une opération d'enregistrement, active l'amplificateur de lecture (6) ainsi que le circuit d'enregistrement (7), sans activer cependant la mémoire intermédiaire (12).

6. Mémoire à semiconducteurs suivant la revendication 4, caractérisée par le fait qu'en amont des entrées, qui sont chargées par les signaux d'adresses, du circuit de décodage de lignes (16) et du circuit de décodage de colonnes (17) est branché un circuit de porte (19a), qui est commandé au moyen de la seconde tension de cadence de sorte que ce circuit de porte est bloqué pendant l'apparition du second niveau de cette tension.

7. Mémoire à semiconducteurs suivant l'une des revendications 1 à 6, caractérisée par le fait que le générateur de tension de cadence (26) comporte deux transistors à effet de champ (P1, N1) possédant des types de canaux différents et dont les bornes de drain sont raccordées à un premier noeud (K1), tandis que la borne de source du premier transistor à effet de champ (P1) est placée à la tension d'alimentation (V_{DD}) et que la borne de source du second transistor à effet de champ (N1) est placée au potentiel de référence (V_{SS}), que la borne de grille du premier transistor à effet de champ (P1) représente une entrée du générateur de tension de cadence (26), qui est raccordée au circuit d'identification de changement de signal, que la borne de grille du second transistor à effet de champ (N1) représente une entrée (27), qui est raccordée au circuit de commande (28), du générateur de tension de cadence, que le premier noeud (K1) est raccordé directement à la première entrée d'une porte NON-OU (39) et à la seconde entrée de cette porte par l'intermédiaire d'un circuit de retardement (40), et que la première sortie (29) du générateur de tension de cadence est raccordée à la sortie de la porte NON-OU (39) et que la seconde entrée (30) du générateur de tension de cadence est raccordée au premier noeud (K1).

8. Mémoire à semiconducteurs suivant la revendication 9, caractérisée par le fait que la borne de grille du second transistor à effet de champ (N1) est raccordée à la sortie d'une porte NON-ET (36), dont la première entrée représente l'entrée (27) du générateur de tension de cadence, qui est raccordée au circuit de commande (28) et dont la seconde entrée (37) est chargée par un signal de sélection de microplaquette.

9. Mémoire à semiconducteurs suivant l'une des revendications 7 ou 8, caractérisée par le fait que la borne de grille du second transistor à effet de champ (N1) est raccordée à la borne de grille d'un troisième transistor à effet de champ (P2), qui possède le même type de canal que le premier transistor et est inséré, par sa voie source-drain, entre la borne de source du premier transistor à effet de champ (P1) et une borne (35') chargée par la tension d'alimentation.

10. Mémoire à semiconducteurs suivant l'une des revendications 7 à 9, caractérisée par le fait que le premier noeud (K1) est raccordé à un circuit de maintien constitué par deux inverseurs (I1,I2) couplés selon un couplage croisé.

11. Mémoire à semiconducteurs suivant l'une des revendications précédentes, caractérisée par le fait que le circuit de commande (28) comporte trois transistors à effet de champ possédant un premier type de canal (NE1 à NE3), dont deux sont raccordés par l'intermédiaire de leurs bornes de grille à deux sorties (11a, 11b) de l'amplificateur de lecture (6), que ces deux transistors à effet de champ (NE1, NE2) sont raccordés par leurs bornes de drain à deux noeuds (52, 53) du circuit et par leurs bornes de source à la borne de drain du troisième transistor à effet de champ (NE3), dont la borne de source est placée au potentiel de référence et dont la borne de grille est raccordée à une entrée de commande (55), que les deux noeuds (52,53) du circuit sont raccordés par l'intermédiaire des voies source-drain d'autres transistors à effet de champ respectifs (P1,P2) possédant le second type de canal, à des bornes (56,57) qui sont raccordées à la tension d'alimentation, la borne de grille de l'un de ces deux autres transistors à effet de champ étant raccordée à la borne de drain de l'autre de ces transistors, et que les noeuds (52,53) du circuit sont raccordés d'une part, par l'intermédiaire d'un transistor de compensation (PE3) dont la grille est raccordée à l'entrée de commande (55), entre eux et, par l'intermédiaire d'inverseurs respectifs (I3,I4), aux entrées d'une porte NON-OU (58), dont la sortie est raccordée à la sortie (28a) du circuit de commande (28).

12. Mémoire à semiconducteurs suivant l'une des revendications 1 à 10, caractérisée par le fait que le circuit de commande (28) est constitué par deux inverseurs (I3 et I4), qui sont raccordés aux sorties (11a,11b) de l'amplificateur de lecture (6) et dont les sorties sont raccordées aux entrées d'une porte NON-OU (58), et que la sortie de la porte NON-OU est raccordée à la sortie du circuit de commande (28).

13. Mémoire à semiconducteurs suivant l'une des revendications 1 à 10, caractérisée par le fait que le circuit de commande (28) comporte trois transistors à effet de champ possédant le premier type de canal (NE11 à NE13), dont deux sont raccordés par l'intermédiaire de leurs bornes de grille à deux sorties (11a,11b) de l'amplificateur de lecture (6), que l'un de ces deux transistors à effet de champ (NE11) est raccordé par l'intermédiaire de sa borne de drain à un premier noeud interne (52) du circuit tandis que l'autre (NE12) est raccordé par l'intermédiaire de sa borne de drain à un premier noeud de sortie (53), que ces deux transistors à effet de champ sont raccordés, par l'intermédiaire de leurs bornes de source, à la borne de drain du troisième transistor à effet de champ (NE13), dont la borne de source est placée au potentiel de référence et dont la borne de grille est raccordée à une entrée de commande (55), que le premier noeud interne (52) et le premier noeud de sortie (53) sont raccordés d'une part, par l'intermédiaire d'un premier transistor de compensation (PE13), entre eux et par l'intermédiaire des voies source-drain de transistors à effet de champ supplémentaires respectifs (PE11, PE12) possédant le second type de canal, à des bornes (56, 57) qui sont chargées par la tension d'alimentation, les bornes de grille des deux transistors à effet de champ supplémentaires étant raccordées à la borne de drain de l'un de ces transistors, qu'il est prévu trois transistors à effet de champ supplémentaires (NE21 à NE23) possédant le premier type de canal et qui sont raccordés, à l'exception des bornes de drain des deux premiers transistors à effet de champ (NE21 et NE22), conformément aux trois transistors à effet de champ possédant le premier type de canal, que la borne de drain du premier transistor à effet de champ supplémentaire (NE22) est raccordée au second noeud interne (52') du circuit et que la borne de drain du second transistor à effet de champ supplémentaire (NE21) est raccordée à un second noeud de sortie (53'), que le second noeud interne (52') et le second noeud de sortie (53') sont raccordés, d'une part, par l'intermédiaire d'un second transistor de compensation (P23), entre eux, et, par l'intermédiaire des voies source-drain d'autres transistors respectifs supplémentaires à effet de champ (PE21, PE22), aux bornes (56, 57) qui sont chargées par la tension d'alimentation, les bornes de grille des autres transistors supplémentaires à effet de champ étant raccordées à la borne de drain de l'un de ces transistors, que les bornes de grille des premier et second transistors de compensation (PE13, PE23) sont raccordées à l'entrée de commande (55) et que les premier et second noeuds de sortie (53,53') sont raccordés par des inverseurs respectifs (I5, I6) aux entrées d'une porte NON-OU (61), dont la sortie est raccordée à la sortie (28a) du circuit de commande (28).
